# EUROPEAN PATENT APPLICATION

(11) **EP 4 773 509 A1**
(43) Date of publication of application: **08.07.2026**
(21) Application number: 25225265.5
(22) Date of filing: 18.12.2025
(51) Int. Cl.: H03K 5/1252, H03K 5/1534, H03K 19/003, H03K 3/0233

(54) **DUAL EDGE SYNCHRONIZER WITH GLITCH PROTECTION**

(30) Priority: 03.01.2025 IN 202541000651
(71) Applicant: NXP B.V., 5656 AG Eindhoven (NL)
(72) Inventor: Barman, Arun Kumar, 5656AG Eindhoven (NL); Gupta, Jhalak, 5656AG Eindhoven (NL)
(74) Representative: Schwarzweller, Thomas

(57) **Abstract**

Dual edge synchronizers and methods of using dual edge synchronizers to filter out glitches are provided. Dual edge synchronizers include a first two flip-flop synchronizer, a second two flip-flop synchronizer in parallel with the first two flip-flop synchronizer, a plurality of gates that receive the outputs from the two synchronizers and implement a gate logic to generate an enable signal and a D input signal that are passed to a latch. The latch generates a dual edge synchronizer output signal, wherein a change in the state of the D input signal is passed as a change in the state of the dual edge synchronizer output signal when the enable signal is high and is not passed as the dual edge synchronizer output signal when the enable signal is low.

## Description

### FIELD OF THE DISCLOSURE

The present disclosure relates to dual edge synchronizers and methods of using dual edge synchronizers to filter out glitches.

### BACKGROUND OF THE DISCLOSURE

In digital circuits, glitch is an issue in many circumstances. Glitch can be produced for various reasons, including, for example, path delay variations from various inputs to the output of a combinational logic circuit, or relative delay in the arrival of inputs of a combinational logic circuit.

The occurrence of a glitch is generally asynchronous with respect to destination clock cycles, so a glitch can be captured randomly as a valid pulse. Convergence at a specific clock domain crossing ("CDC") boundary is a classic example where a source domain clock is not available to capture the combinational output at the CDC interface. In such instances, small glitches generated by the asymmetric delay of different paths of a combinational logic circuit tend to be passed erroneously as valid pulses, which may cause functional failure manifested in in gate level simulation and silicon.

Conventionally, in digital systems with multiple clock domains, a two flip-flop synchronizer is used to synchronize a single bit signal. Examples of when the source domain signal may have glitches are: (1) if its generation is fed from the output of a combinational logic circuit due to an unavoidable functional or protocol constraint; or (2) if its generation is fed from a primary input of a chip with external noise that appears as glitch. In such situations, the position of the glitch with respect to the destination clock becomes important. For example, if the glitch happens around the active edge of the destination clock, it may get captured as a pulse, which is functionally not valid as a result, and thus the functionality fails randomly.

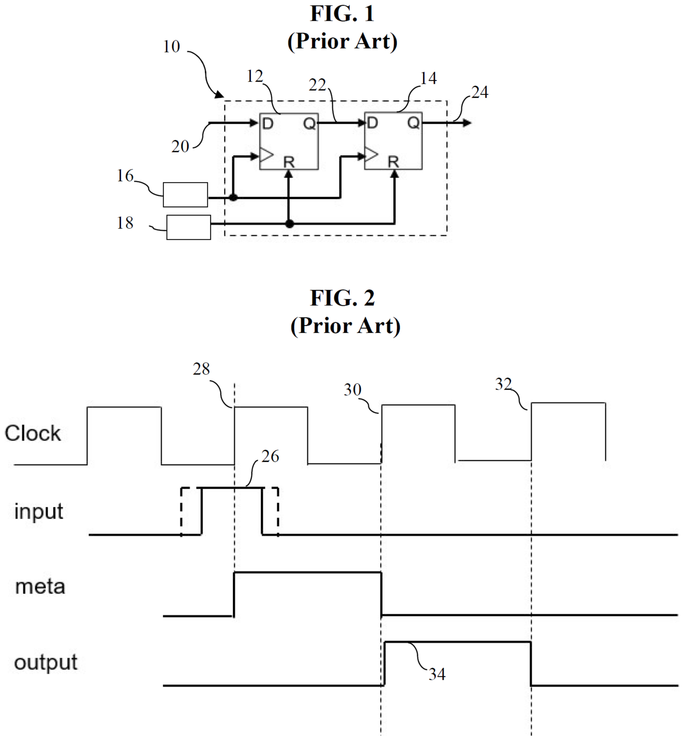

Figure 1 illustrates one example of a conventional two flip-flop synchronizer 10. As shown, the two flip-flop synchronizer 10 includes two D flip-flops, specifically a first flip-flop 12 in series with a second flip-flop 14. Each of the two flip-flops is connected to a clock 16 and a reset latch 18. The first flip-flop 12 may be referred to as a meta-flop because its operation may result in a metastable state. However, the metastable period is resolved within one clock cycle. The first flip-flop 12 receives the initial input 20 as its D input, and the second flip-flop 14 receives the meta output 22 of the first flip-flop 12 as its D input. Such two flip-flop synchronizers work on a single clock edge, and as shown in Figure 1, the first flip-flop 12 and second flip-flop 14 each work on the rising edge of the clock signal. The two flip-flop synchronizer 10 requires a minimum of two clock cycles to generate its synchronized output 24.

Figure 2 illustrates a timing diagram for the two flip-flop synchronizer 10 of Figure 1, providing an example of how such a two flip-flop synchronizer may pass a random glitch as a valid pulse. In Figure 2, the Clock line represents the clock cycle of the clock 16 of Figure 1, the input line represents the input 20 of Figure 1, the meta line represents the meta output 22 of Figure 1, and the output line represents the synchronized output 24 of Figure 1. In the illustrated example, the input line includes a glitch 26, which is less than a pulse width, and which occurs such that it crosses the leading edge of the first clock cycle 28. The solid line represents the actual size of the glitch 26 in the example, but the dotted line shows the extent to which the size of the glitch 26 may vary. In response, the state of the first flip-flop 12 changes and the meta output 22 as shown in the meta line changes from low to high at the leading edge of the first clock cycle 28, and remains high until the leading edge of the second clock cycle 30.

Further as shown in Figure 2, because the glitch 26 is no longer present at the leading edge of the second clock cycle 30, the state of the first flip-flop 12 (Figure 1), as shown in the meta line, is reset to low when that leading edge occurs. As shown in the output line, the state of the second flip-flop 14 changes at the leading edge of the second clock cycle 30, resulting in the output changing to high. Because the meta output 22 of the meta line is no longer high at the leading edge of the third clock cycle 32, the state of the second flip-flop 14 is reset and the output changes to low at the leading edge of the third clock cycle 32. The glitch 26 is thus erroneously passed by the two flip-flop synchronizer 10 as a pulse 34 within the output line.

### BRIEF DESCRIPTION OF THE DRAWINGS

Specific examples have been chosen for purposes of illustration and description, and are shown in the accompanying drawings, forming a part of the specification.
FIG. 1 illustrates a logic circuit for one example of a Prior Art two flip-flop synchronizer.
FIG. 2 illustrates a timing diagram of one example of the operation of the Prior Art two flip-flop synchronizer of Figure 1 when passing a glitch as a valid pulse.
FIG. 3 illustrates a logic circuit for one example of a dual edge synchronizer of the present technology.
FIG. 4 illustrates a logic circuit for a variation of the example of a dual edge synchronizer of the present technology.
FIG. 5 illustrates a logic circuit of the dual edge synchronizer of Figure 3 in a system application.
FIG. 6 illustrates a timing diagram of one example of the operation of a dual edge synchronizer of the present technology functioning to prevent passing logic high glitches as valid pulses.
FIG. 7 illustrates a timing diagram of one example of the operation of a dual edge synchronizer of the present technology functioning to pass valid high pulses.
FIG. 8 illustrates a timing diagram of one example of the operation of a dual edge synchronizer of the present technology functioning to prevent passing logic low glitches as valid pulses.
FIG. 9 illustrates a timing diagram of one example of the operation of a dual edge synchronizer of the present technology functioning to pass valid low pulses.
Figure 10 illustrates one example of a method of using a dual edge synchronizer of the present technology.

While various embodiments discussed herein are amenable to modifications and alternative forms, aspects thereof have been shown by way of example in the drawings and are described in detail herein. It should be understood, however, that the disclosure is not limited to the particular embodiments described, and instead is meant to include all modifications, equivalents, and alternatives falling within the scope of the disclosure. In addition, the terms "example" and "embodiment" as used throughout this application is only by way of illustration, and not limitation, the Figures are not necessarily drawn to scale, and the use of the same reference symbols in different drawings indicates similar or identical items unless otherwise noted. The term "configured to" as used herein with respect to a component being "configured to" have certain structural characteristics in specified circumstances or to perform a specified function means that the component is structurally formed such that the component meets the structural characteristics in the specified circumstances or performs the function without further modification. The term "operatively connected" herein means that the two components electrically connected, whether directly or indirectly, in such a way that the disclosed signals are passed and received at least from one of the components to the other as described herein. The term "about" as used herein with reference to any measurement or physical characteristic means approximately, and includes the stated measurement or physical characteristic plus or minus an amount that is within an acceptable margin of error or other amount of variance that maintains the desired functionality.

### DETAILED DESCRIPTION

For at least the reason that it is desirable to reduce or prevent glitches from being erroneously passed as valid pulses, or for one or more other reasons, it would be advantageous if new or improved systems could be developed, and/or improved methods of operation or implementation could be developed, so as to address any one or more of the concerns discussed above or to address one or more other concerns or provide one or more benefits.

In view of these and other considerations, dual edge synchronizers and methods of using dual edge synchronizers of the present technology may be used to identify and filter out glitches in an input signal. Generally, dual edge synchronizers of the present technology may operate by sampling an input signal at different time instances during synchronization and then processing those samples to generate the valid output. For sampling at different times, dual edge synchronizers of the present technology use both edges of clock and then use an appropriate logical operation, implemented by gate logic, to accept or reject the sampled input. Dual edge synchronizers of the present technology successfully filter glitches that are less than one half of a clock cycle in width. In preferred examples, dual edge synchronizers and methods of using dual edge synchronizers of the present technology do not take any additional time (in terms of clock cycles) to generate the valid output as compared to conventional two stage synchronizers. As a result, dual edge synchronizers and methods of using dual edge synchronizers of the present technology improve the robustness of a circuit by improving the circuit's immunity to glitches while avoiding functional failures.

In general, dual edge synchronizers of the present technology include a first two flip-flop synchronizer, a second two flip-flop synchronizer, a plurality of gates that implement a gate logic circuit (or gate logic), and a latch. For any given dual edge synchronizer, each of the components are operatively connected to each other, as described more fully below. The first two flip-flop synchronizer includes a first rising edge D flip-flop in series with a first falling edge D flip-flop. The first two flip-flop synchronizer receives an input signal and a clock signal, and generates a first synchronizer output signal. The second two flip-flop synchronizer is in parallel with the first two flip-flop synchronizer, and includes a second falling edge D flip-flop in series with a second rising edge D flip-flop. The order of the rising and falling edge flip-flops in the second two flip-flop synchronizer should be opposite of the order of the of the rising and falling edge flip-flops in the first two flip-flop synchronizer. The second two flip-flop synchronizer also receives the input signal and the clock signal, and generates a second synchronizer output signal. The plurality of gates that implement the gate logic receive the first synchronizer output signal and the second synchronizer output signal, and generate an enable signal and a D input signal. The plurality of gates may include any suitable gates, as long as they are selected, ordered, and configured to implement the desired gate logic. The latch receives the enable signal and the D input signal and generates a dual edge synchronizer output signal. A change in the state of the D input signal is passed as a change in the state of the dual edge synchronizer output signal when the enable signal is high and is not passed as the dual edge synchronizer output signal when the enable signal is low. As one of ordinary skill in the art would understand, the use of the terms "high" and "low" herein refer to the signal value being either 1 ("high") or 0 ("low").

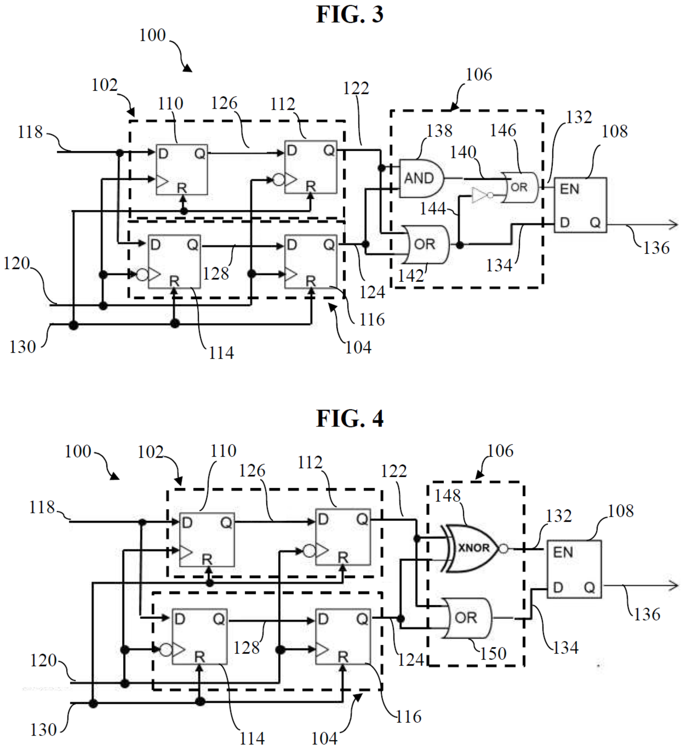

Figures 3 and 4 each illustrate a logic circuit diagram for variations of one example of a dual edge synchronizer 100 of the present technology. As shown in both Figures 3 and 4, the dual edge synchronizer 100 includes a first two flip-flop synchronizer 102, a second two flip-flop synchronizer 104, a plurality of gates 106 that implement a gate logic, and a latch 108. The only difference between the variations illustrated in Figure 3 and Figure 4 is in the configuration, including types and order, of gates in the plurality of gates 106 that implement the gate logic.

Referring to Figures 3 and 4, the first two flip-flop synchronizer 102 includes a first rising edge D flip-flop 110 operatively connected to, in series with and preceding, a first falling edge D flip-flop 112. The second two flip-flop synchronizer 104 is in parallel with the first two flip-flop synchronizer 102. The second two flip-flop synchronizer 104 includes a second falling edge D flip-flop 114 operatively connected to, in series with and preceding, a second rising edge D flip-flop 116. The first two flip-flop synchronizer 102 and the second two flip-flop synchronizer 104 each receive an input signal 118 and a clock signal 120. The first two flip-flop synchronizer 102 generates a first synchronizer output signal 122 and the second two flip-flop synchronizer 104 generates a second synchronizer output signal 124.

More specifically, the first rising edge D flip-flop 110 of the first two flip-flop synchronizer 102 receives the input signal 118 and the clock signal 120, and outputs a first synchronizer meta signal 126. The first falling edge D flip-flop 112 receives the clock signal 120 and the first synchronizer meta signal 126, and outputs the first synchronizer output signal 122. Likewise, the second falling edge D flip-flop 114 of the second two flip-flop synchronizer 104 receives the input signal 118 and the clock signal 120, and outputs a second synchronizer meta signal 128. The second rising edge D flip-flop 116 receives the clock signal 120 and the second synchronizer meta signal 128, and outputs the second synchronizer output signal 124. It should be noted that the metastable state of each of the two flip-flop synchronizers is resolved within one half of a clock cycle. Each of the D flip-flops in the first synchronizer 102 and the second synchronizer 104 may also be connected to a reset signal 130.

The plurality of gates 106 that implement the gate logic receive the first synchronizer output signal 122 and the second synchronizer output signal 124, and generate an enable signal 132 and a D input signal 134. The latch 108 receives the enable signal 132 and the D input signal 134, and generates a dual edge synchronizer output signal 136. The latch 108 is configured to operate, and operates, such that a change in the state of the D input signal 134 is passed as a change in the state of the dual edge synchronizer output signal 136 when the enable signal 132 is high and is not passed as the dual edge synchronizer output signal 136 when the enable signal 132 is low.

The configuration of the plurality of gates 106, including the types of gates and the order of the gates, may be any suitable configuration that implements the desired gate logic. Table 1 below sets forth the truth table for the gate logic to be implemented.

**Table 1**

| **Inputs** | | **Outputs** | |
|---|---|---|---|
| **A** | **B** | **Latch EN** | **Latch D** |
| **0** | **0** | **1** | **0** |
| **0** | **1** | **0** | **1** |
| **1** | **0** | **0** | **1** |
| **1** | **1** | **1** | **1** |

As shown in Table 1, the input A corresponds to the first synchronizer output signal 122, the input B corresponds to the second synchronizer output signal 124, the Latch EN corresponds to the enable signal 132 and the Latch D corresponds to the D input signal 134. Accordingly, when both the A input (first synchronizer output signal 122) and the B input (second synchronizer output signal 124) are equal, i.e., both are either high or low, then the Latch EN (enable signal 132) is high and the Latch D (D input signal 134) is passed as the dual edge synchronizer output signal 136. In contrast, when the A input (first synchronizer output signal 122) and the B input (second synchronizer output signal 124) are not equal, i.e., one is high and the other is low, then the Latch EN (enable signal 132) is low and the Latch D (D input signal 134) is not passed as the dual edge synchronizer output signal 136. Further, the Latch D (D input signal 134) is high when at least one of the A input (first synchronizer output signal 122) or the B input (second synchronizer output signal 124) is high, and the Latch D (D input signal 134) is low when at least one of the A input (first synchronizer output signal 122) or the B input (second synchronizer output signal 124) is low.

Figures 3 and 4 illustrate two examples of sets of gates that implement the gate logic having the truth table of Table 1. Referring to Figure 3, the plurality of gates 106 includes an AND gate 138 that receives the first synchronizer output signal 122 and the second synchronizer output signal 124. The AND gate 138 outputs an AND gate output 140. The plurality of gates 106 also includes a first OR gate 142 that receives the first synchronizer output signal 122 and the second synchronizer output signal 124. The first OR gate 142 outputs the D input signal 134 and a first OR gate output 144. The plurality of gates 106 also includes a second OR gate 146 that receives the AND gate output 140 and the first OR gate output 144 (after being inverted by an inverter as also shown), and outputs the enable signal 132. Referring to Figure 4, the plurality of gates 106 includes an XNOR gate 148 that receives the first synchronizer output signal 122 and the second synchronizer output signal 124. The XNOR gate 148 outputs the enable signal 132. The plurality of gates 106 also includes an OR gate 150 that receives the first synchronizer output signal 122 and the second synchronizer output signal 124. The OR gate 150 outputs the D input signal 134.

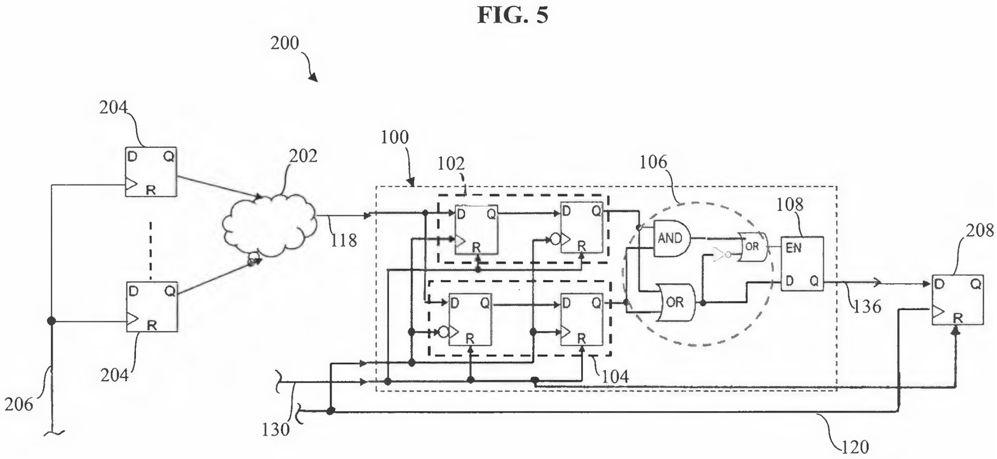

Figure 5 illustrates a logic circuit of the dual edge synchronizer 100 of the present technology in a system application 200. The dual edge synchronizer 100 is shown as being the variation of Figure 3, but it should be understood that the variation of Figure 4, or any other comparable or similar dual edge synchronizer of the present technology could be used. The dual edge synchronizer 100 includes all of the components of the variation of the dual edge synchronizer 100 shown and discussed with respect to Figure 3 above. For example, the dual edge synchronizer 100 includes the first two flip-flop synchronizer 102, the second two flip-flop synchronizer 104, the plurality of gates 106 that implement a gate logic, and the latch 108, all as shown in Figure 3. The system application 200 includes a logic cloud 202, which is the source of the input signal 118. Accordingly, the input signal 118 received by the dual edge synchronizer 100 is received from the logic cloud 202. The input to the logic cloud may include one or more source flip-flops 204, which may receive a source clock signal 206. In this example, the source clock signal 206 is not passed to the dual edge synchronizer 100. Instead, the system application 200 includes a destination D flip-flop 208 that receives the dual edge synchronizer output signal 136 as its D input. The clock signal 120 is a destination clock signal, which is provided to the dual edge synchronizer 100, as well as to the destination D flip-flop 208 as its clock input. It should be appreciated that the source clock signal 206 and the clock signal (destination clock signal) 120 are asynchronous relative to one another.

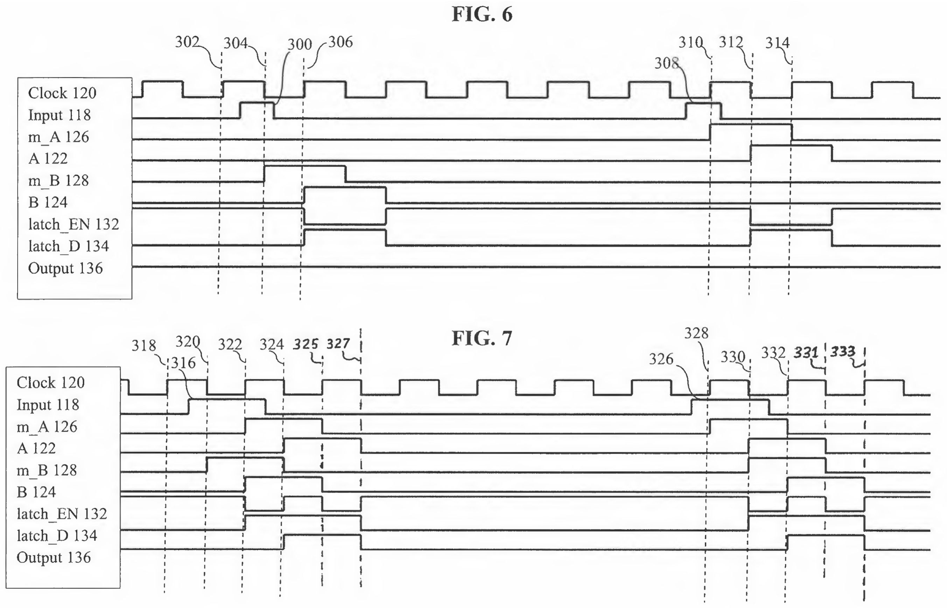

Figures 6 through 9 illustrate timing diagrams of the operation of a dual edge synchronizer 100 of the present technology, which may be either variation of the dual edge synchronizer 100 shown in Figures 3 and 4. Accordingly, the illustrated signals are labeled with their corresponding reference numbers as shown in Figures 3 and 4.

Figure 6 illustrates a timing diagram of one example of the operation of a dual edge synchronizer 100 of the present technology functioning to prevent passing logic high glitches having a width of less than one half of a clock cycle as valid pulses. As shown, a first logic high glitch 300 occurs in the input signal 118 between a first rising edge 302 and a first falling edge 304 of the clock signal 120. The first logic high glitch 300 crosses (is occurring at the same time as) the first falling edge 304 of the clock signal 120, but does not cross the first rising edge 302, and the second rising edge 306 of the clock signal 120. Referring to Figures 3 and 6, because the first logic high glitch 300 does not cross the first rising edge 302 of the clock signal, the first synchronizer meta signal 126 of the first rising edge flip-flop 110 of the first two flip-flop synchronizer remains low. Because the first synchronizer meta signal 126 is low at the first falling edge 304, the first synchronizer output signal 122 remains low. In contrast, because the first logic high glitch 300 crosses the first falling edge 304, the change in state from low to high in the input signal 118 of the first logic high glitch 300 is detected and passed by the second falling edge flip-flop 114 of the second two flip-flop synchronizer 104, resulting in the second synchronizer meta signal 128 changing state from low to high. Correspondingly, because the second synchronizer meta signal 128 is high at the second rising edge 306 of the clock signal 120, the second synchronizer output signal 124 changes from low to high at the second rising edge 306 of the clock signal 120. The first synchronizer output signal 122 and the second synchronizer output signal 124 are passed to the plurality of gates 106, which implement the gate logic to generate the enable signal 132 and the D input signal 134 in accordance with the truth table shown in Table 1. Accordingly, at the second rising edge 306 of the clock signal 120, the first synchronizer output signal 122 is low and the second synchronizer output signal 124 is high. The D input signal 134 changes from low to high because at least one of the first synchronizer output signal 122 and the second synchronizer output signal 124, specifically the second synchronizer output signal 124, is high. However, the enable signal, which was high, changes state to low because the first synchronizer output signal 122 and the second synchronizer output signal 124 are not equal. Accordingly, the first logic high glitch 300 is not passed and the state of the dual edge synchronizer output signal 136 remains low.

As also shown in Figure 6, a second logic high glitch 308 occurs in the input signal 118 such that it crosses the seventh rising edge 310 of the clock signal 120, but does not cross the seventh falling edge 312 of the clock signal 120. Referring to Figures 3 and 6, because the second logic high glitch 308 crosses the seventh rising edge 310 of the clock signal 120, the first synchronizer meta signal 126 of the first rising edge flip-flop 110 of the first two flip-flop synchronizer 102 changes state from low to high at the seventh rising edge 310 of the clock signal 120. Because the first synchronizer meta signal 126 is high at the seventh falling edge 312, the first synchronizer output signal 122 changes state from low to high. In contrast, because the second logic high glitch 308 does not cross the seventh falling edge 312, the change in state from low to high in the input signal 118 of the second logic high glitch 308 is not detected and not passed by the second falling edge flip-flop 114 of the second two flip-flop synchronizer 104, resulting in the second synchronizer meta signal 128 remaining low. Correspondingly, because the second synchronizer meta signal 128 is low at the eighth rising edge 314 of the clock signal 120, the second synchronizer output signal 124 remains low at the eighth rising edge 314 of the clock signal 120. The first synchronizer output signal 122 and the second synchronizer output signal 124 are passed to the plurality of gates 106, which implement the gate logic to generate the enable signal 132 and the D input signal 134 in accordance with the truth table shown in Table 1. Accordingly, at the eighth rising edge 314 of the clock signal 120, the first synchronizer output signal 122 is high and the second synchronizer output signal 124 is low. The D input signal 134 changes from low to high because at least one of the first synchronizer output signal 122 and the second synchronizer output signal 124, specifically the first synchronizer output signal 122, is high. However, the enable signal, which was high, changes state to low because the first synchronizer output signal 122 and the second synchronizer output signal 124 are not equal. Accordingly, the second logic high glitch 308 is not passed and the state of the dual edge synchronizer output signal 136 remains low.

Figure 7 illustrates a timing diagram of one example of the operation of a dual edge synchronizer of the present technology functioning to pass valid high pulses, where the valid high pulses have a width of at least one clock cycle. As shown in Figure 7, a first valid high pulse 316 occurs in the input signal 118 such that it does not cross a first rising edge 318 of the clock signal 120, but does cross a first falling edge 320 and a second rising edge 322 of the clock signal 120. Because the input signal is low at the first rising edge 318 of the clock signal 120, the first synchronizer meta signal 126 remains low at the first rising edge 318 of the clock signal 120. However, the first synchronizer meta signal 126 changes state from low to high at the second rising edge 322 of the clock signal 120 because the first valid high pulse 316 crosses the second rising edge 322 of the clock signal 120. The first synchronizer output signal 122 changes state from low to high at the second falling edge 324 of the clock signal 120. The second synchronizer meta signal 128 changes state from low to high at the first falling edge 320 of the clock signal 120 because the first valid high pulse 316 crosses the first falling edge 320 of the clock signal 120. The second synchronizer output signal 124 changes state from low to high at the second rising edge 322 of the clock signal 120. At the second rising edge 322 of the clock signal 120, the first synchronizer output signal 122 is low and the second synchronizer output signal 124 is high. In accordance with the gate logic implementing the truth table of Table 1, the D input signal 134 changes state from low to high, but the enable signal 132, which was high, changes state to low, so the dual edge synchronizer output signal 136 remains low. However, at the second falling edge 324 of the clock signal 120, both the first synchronizer output signal 122 and the second synchronizer output signal 124 are high. Thus, in accordance with the gate logic implementing the truth table of Table 1, the D input signal 134 remains high, and the enable signal 132 changes state from low to high, so the dual edge synchronizer output signal 136 changes state from low to high, passing (or commencing the passing of) the first valid high pulse 316.

Further as shown in Figure 7, the first valid high pulse 316 in the input signal 118 ends (that is, the input signal transitions back to a low level) between the second rising edge 322 and the second falling edge 324 of the clock signal 120. The input signal 118 then subsequently remains low at the time of a third rising edge 325 of the clock signal 120, which occurs subsequent to the second falling edge 324, as well as remains low at the time of a third falling edge 327 of the clock signal 120, which occurs subsequent to the third rising edge 325. Subsequent to the ending of the first valid high pulse 316, the second synchronizer meta signal 128 switches from high to low at the time of the second falling edge 324 of the clock signal 120, and the first synchronizer meta signal 126 switches from high to low at the time of the third rising edge 325. Additionally, at the third rising edge 325 of the clock signal 120, the first synchronizer output signal 122 is high but the second synchronizer output signal 124 changes state from high to low. In accordance with the gate logic implementing the truth table of Table 1, the enable signal 132 changes state from high to low, and the D input signal 134 remains high. Consequently, at and immediately after the third rising edge 325, the dual edge synchronizer output signal 136 remains high. However, at the third falling edge 327 of the clock signal 120, the second synchronizer output signal 124 remains low and additionally the first synchronizer output signal 122 becomes low as well. In accordance with the gate logic implementing the truth table of Table 1, the D input signal 134 transitions from high to low, but the enable signal 132 changes state from low to high, so the dual edge synchronizer output signal 136 changes state from high to low. Accordingly, at the third falling edge 327, the passing of the first valid high pulse 316 is completed.

Figure 7 also illustrates a second valid high pulse 326, which occurs in the input signal 118 such that it crosses an eighth rising edge 328 and an eighth falling edge 330 of the clock signal 120. Because the input signal is high at the eighth rising edge 328 of the clock signal 120, the first synchronizer meta signal 126 changes state from low to high at the eighth rising edge 328 of the clock signal 120. The first synchronizer output signal 122 changes state from low to high at the eighth falling edge 330 of the clock signal 120. The second synchronizer meta signal 128 also changes state from low to high at the eighth falling edge 330 of the clock signal 120 because the second valid high pulse 326 crosses the eighth falling edge 330 of the clock signal 120. The second synchronizer output signal 124 changes state from low to high at the ninth rising edge 332 of the clock signal 120. At the ninth rising edge 332 of the clock signal 120, the first synchronizer output signal 122 is high and the second synchronizer output signal 124 is high. In accordance with the gate logic implementing the truth table of Table 1, the D input signal 134 changes state from low to high at the eighth falling edge 330 of the clock signal 120 and remains high at the ninth rising edge 332 of the clock signal. The enable signal 132 changes state from low to high at the ninth rising edge 332 of the clock signal 120, so the dual edge synchronizer output signal 136 changes state from low to high, passing (or commencing the passing of) the second valid high pulse 326.

Further as shown in Figure 7, the second valid high pulse 326 in the input signal 118 ends (that is, the input signal transitions back to a low level) between the eighth falling edge 330 and the ninth rising edge 332 of the clock signal 120. The input signal 118 then subsequently remains low at the time of a ninth falling edge 331 of the clock signal 120, which occurs subsequent to the ninth rising edge 332, and also at the time of a tenth rising edge 333 of the clock signal 120, which occurs subsequent to the ninth falling edge 331. Subsequent to the ending of the second valid high pulse 326, the first synchronizer meta signal 126 switches from high to low at the time of the ninth rising edge 332 of the clock signal 120, and the second synchronizer meta signal 128 switches from high to low at the time of the ninth falling edge 331. Additionally, at the ninth falling edge 331 of the clock signal 120, the second synchronizer output signal 124 is high but the first synchronizer output signal 122 changes state from high to low. In accordance with the gate logic implementing the truth table of Table 1, the enable signal 132 changes state from high to low, and the D input signal 134 remains high. Consequently, at and immediately after the ninth falling edge 331, the dual edge synchronizer output signal 136 remains high. However, at the tenth rising edge 333 of the clock signal 120, the first synchronizer output signal 122 remains low and additionally the second synchronizer output signal 124 becomes low as well. In accordance with the gate logic implementing the truth table of Table 1, the D input signal 134 transitions from high to low, but the enable signal 132 changes state from low to high, so the dual edge synchronizer output signal 136 changes state from high to low. Accordingly, at the tenth rising edge 333, the passing of the second valid high pulse 326 is completed.

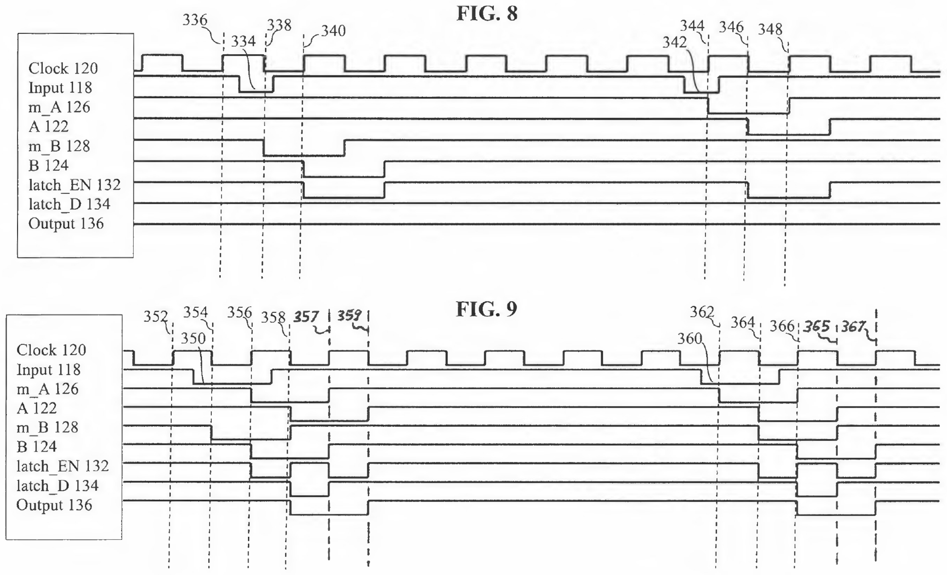

Figure 8 illustrates a timing diagram of one example of the operation of a dual edge synchronizer 100 of the present technology functioning to prevent passing logic low glitches having a width of less than one half of a clock cycle as valid pulses. As shown, a first logic low glitch 334 occurs in the input signal 118 between a first rising edge 336 and a first falling edge 338 of the clock signal 120. The first logic low glitch 334 crosses the first falling edge 338 of the clock signal 120, but does not cross the first rising edge 336, or the second rising edge 340 of the clock signal 120. Because the first logic low glitch 334 does not cross the first rising edge 336 of the clock signal 120, the first synchronizer meta signal 126 remains high. Because the first synchronizer meta signal 126 is high at the first falling edge 338, the first synchronizer output signal 122 remains high. In contrast, because the first logic low glitch 334 crosses the first falling edge 338, the change in state from high to low in the input signal 118 of the first logic low glitch 334 results in the second synchronizer meta signal 128 changing state from high to low. Correspondingly, because the second synchronizer meta signal 128 is low at the second rising edge 340 of the clock signal 120, the second synchronizer output signal 124 changes from high to low at the second rising edge 340 of the clock signal 120. The first synchronizer output signal 122 and the second synchronizer output signal 124 are passed to the plurality of gates 106, which implement the gate logic to generate the enable signal 132 and the D input signal 134 in accordance with the truth table shown in Table 1. Accordingly, at the second rising edge 340 of the clock signal 120, the first synchronizer output signal 122 is high and the second synchronizer output signal 124 is low. The D input signal 134 remains high at the second rising edge 340 of the clock signal 120 because at least one of the first synchronizer output signal 122 and the second synchronizer output signal 124, specifically the first synchronizer output signal 122, is high. However, the enable signal 132, which was high, changes state to low because the first synchronizer output signal 122 and the second synchronizer output signal 124 are not equal. Accordingly, the first logic low glitch 334 is not passed and the state of the dual edge synchronizer output signal 136 remains high.

As also shown in Figure 8, a second logic low glitch 342 occurs in the input signal 118 such that it crosses the seventh rising edge 344 of the clock signal 120, but does not cross the seventh falling edge 346 of the clock signal 120. Because the second logic low glitch 342 crosses the seventh rising edge 344 of the clock signal 120, the first synchronizer meta signal 126 changes state from high to low at the seventh rising edge 344 of the clock signal 120. Because the first synchronizer meta signal 126 is low at the seventh falling edge 346, the first synchronizer output signal 122 changes state from high to low. In contrast, because the second logic low glitch 342 does not cross the seventh falling edge 346 of the clock signal 120, the second synchronizer meta signal 128 remains high. Correspondingly, because the second synchronizer meta signal 128 is high at the eighth rising edge 348 of the clock signal 120, the second synchronizer output signal 124 remains high at the eighth rising edge 348 of the clock signal 120. The first synchronizer output signal 122 and the second synchronizer output signal 124 are passed to the plurality of gates 106, which implement the gate logic to generate the enable signal 132 and the D input signal 134 in accordance with the truth table shown in Table 1. Accordingly, at the eighth rising edge 348 of the clock signal 120, the first synchronizer output signal 122 is low and the second synchronizer output signal 124 is high. The D input signal 134 remains high because at least one of the first synchronizer output signal 122 and the second synchronizer output signal 124, specifically the second synchronizer output signal 124, is high. However, the enable signal 132, which was high, changes state to low because the first synchronizer output signal 122 and the second synchronizer output signal 124 are not equal. Accordingly, the second logic low glitch 342 is not passed and the state of the dual edge synchronizer output signal 136 remains high.

Figure 9 illustrates a timing diagram of one example of the operation of a dual edge synchronizer of the present technology functioning to pass valid low pulses, where the valid low pulses have a width of at least one clock cycle. As shown in Figure 9, a first valid low pulse 350 occurs in the input signal 118 such that it does not cross a first rising edge 352 of the clock signal 120, but does cross a first falling edge 354 and a second rising edge 356 of the clock signal 120. Because the input signal is high at the first rising edge 352 of the clock signal 120, the first synchronizer meta signal 126 remains high at the first rising edge 352 of the clock signal 120. However, the first synchronizer meta signal 126 changes state from high to low at the second rising edge 356 of the clock signal 120 because the first valid low pulse 350 crosses the second rising edge 356 of the clock signal 120. The first synchronizer output signal 122 changes state from high to low at the second falling edge 358 of the clock signal 120. The second synchronizer meta signal 128 changes state from high to low at the first falling edge 354 of the clock signal 120 because the first valid low pulse 350 crosses the first falling edge 354 of the clock signal 120. The second synchronizer output signal 124 changes state from high to low at the second rising edge 356 of the clock signal 120. At the second rising edge 356 of the clock signal 120, the first synchronizer output signal 122 is high and the second synchronizer output signal 124 is low. In accordance with the gate logic implementing the truth table of Table 1, the D input signal 134 remains high, and the enable signal 132, which was high, changes state to low, so the dual edge synchronizer output signal 136 remains high. However, at the second falling edge 358 of the clock signal 120, both the first synchronizer output signal 122 and the second synchronizer output signal 124 are low. Thus, in accordance with the gate logic implementing the truth table of Table 1, the D input signal 134 switches to low, and the enable signal 132 changes state from low to high, so the dual edge synchronizer output signal 136 changes state from high to low, passing the first valid low pulse 350.

Further as shown in Figure 9, the first valid low pulse 350 in the input signal 118 ends (that is, the input signal transitions back to a high level) between the second rising edge 356 and the second falling edge 358 of the clock signal 120. The input signal 118 then subsequently remains high at the time of a third rising edge 357 of the clock signal 120, which occurs subsequent to the second falling edge 358, as well as remains high at the time of a third falling edge 359 of the clock signal 120, which occurs subsequent to the third rising edge 357. Subsequent to the ending of the first valid low pulse 350, the second synchronizer meta signal 128 switches from low to high at the time of the second falling edge 358 of the clock signal 120, and the first synchronizer meta signal 126 switches from low to high at the time of the third rising edge 357. Additionally, at the third rising edge 357 of the clock signal 120, the first synchronizer output signal 122 is low but the second synchronizer output signal 124 changes state from low to high. In accordance with the gate logic implementing the truth table of Table 1, the enable signal 132 changes state from high to low, and the D input signal 134 changes from low to high. Consequently, at and immediately after the third rising edge 357, the dual edge synchronizer output signal 136 remains low. However, at the third falling edge 359 of the clock signal 120, the second synchronizer output signal 124 remains high and additionally the first synchronizer output signal 122 becomes high as well. In accordance with the gate logic implementing the truth table of Table 1, the D input signal 134 remains high, but the enable signal 132 changes state from low to high, so the dual edge synchronizer output signal 136 changes state from low to high. Accordingly, at the third falling edge 359, the passing of the first valid low pulse 350 is completed.

Figure 9 also illustrates a second valid low pulses 360, which occurs in the input signal 118 such that it crosses an eighth rising edge 362 and an eighth falling edge 364 of the clock signal 120. Because the input signal is low at the eighth rising edge 362 of the clock signal 120, the first synchronizer meta signal 126 changes state from high to low at the eighth rising edge 362 of the clock signal 120. The first synchronizer output signal 122 changes state from high to low at the eighth falling edge 364 of the clock signal 120. The second synchronizer meta signal 128 also changes state from high to low at the eighth falling edge 364 of the clock signal 120 because the second valid low pulse 360 crosses the eighth falling edge 364 of the clock signal 120. The second synchronizer output signal 124 changes state from high to low at the ninth rising edge 366 of the clock signal 120. At the ninth rising edge 366 of the clock signal 120, the first synchronizer output signal 122 is low and the second synchronizer output signal 124 is low. In accordance with the gate logic implementing the truth table of Table 1, the D input signal 134 changes state from high to low, and the enable signal 132 changes state from low to high, so the dual edge synchronizer output signal 136 changes state from high to low, passing the valid low pulse 360.

Further as shown in Figure 9, the second valid low pulse 360 in the input signal 118 ends (that is, the input signal transitions back to a high level) between the eighth falling edge 364 and the ninth rising edge 366 of the clock signal 120. The input signal 118 then subsequently remains high at the time of a ninth falling edge 365 of the clock signal 120, which occurs subsequent to the ninth rising edge 366, and also at the time of a tenth rising edge 367 of the clock signal 120, which occurs subsequent to the ninth falling edge 365. Subsequent to the ending of the second valid low pulse 360, the first synchronizer meta signal 126 switches from low to high at the time of the ninth rising edge 366 of the clock signal 120, and the second synchronizer meta signal 128 switches from low to high at the time of the ninth falling edge 365. Additionally, at the ninth falling edge 365 of the clock signal 120, the second synchronizer output signal 124 is low but the first synchronizer output signal 122 changes state from low to high. In accordance with the gate logic implementing the truth table of Table 1, the enable signal 132 changes state from high to low, and the D input signal 134 switches from low to high. Consequently, at and immediately after the ninth falling edge 365, the dual edge synchronizer output signal 136 remains low. However, at the tenth rising edge 367 of the clock signal 120, the first synchronizer output signal 122 remains high and additionally the second synchronizer output signal 124 becomes high as well. In accordance with the gate logic implementing the truth table of Table 1, the D input signal 134 remains high, but the enable signal 132 changes state from low to high, so the dual edge synchronizer output signal 136 changes state from low to high. Accordingly, at the tenth rising edge 367, the passing of the second valid low pulse 360 is completed.

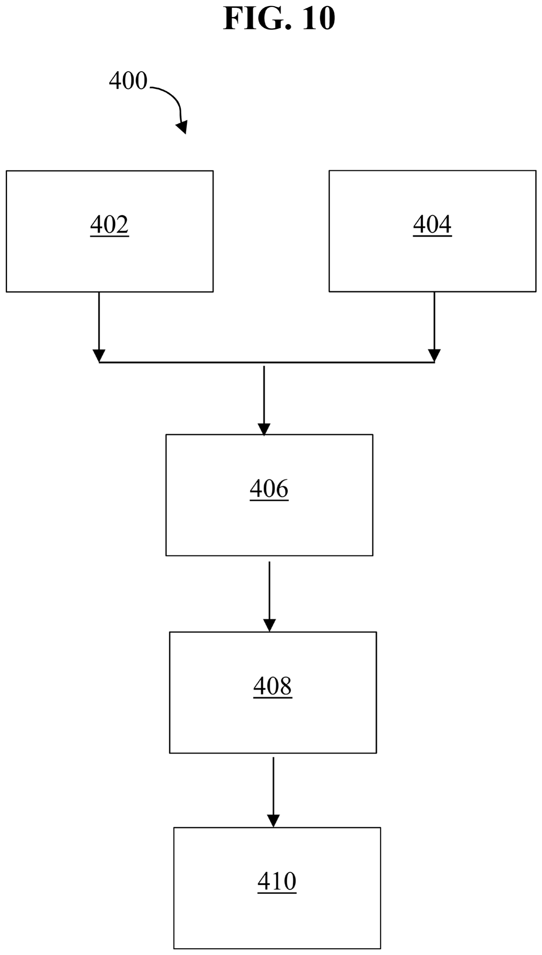

Figure 10 illustrates one example of a method 400 of using a dual edge synchronizer of the present technology, which may be either variation as described above with respect to Figures 3 and 4, or any other dual edge synchronizer of the present technology. The method 400 includes step 402, which includes receiving an input signal and a clock signal by a first two flip-flop synchronizer, and generating by the first two flip-flop synchronizer a first synchronizer output signal. The first two flip-flop synchronizer includes a first rising edge D flip-flop in series with a first falling edge D flip-flop, such as the first two flip-flop synchronizer 102 shown in Figures 3 and 4. Step 402 of receiving an input signal and a clock signal by a first two flip-flop synchronizer, and generating by the first two flip-flop synchronizer a first synchronizer output signal may include: receiving, by the first rising edge D flip-flop, the input signal and the clock signal; outputting, by the first rising edge D flip-flop, a first synchronizer meta signal; receiving, by the first falling edge D flip-flop the clock signal and the first synchronizer meta signal; and outputting by the first falling edge D flip-flop the first synchronizer output signal.

The method 400 also includes 404, which includes receiving an input signal and a clock signal by a second two flip-flop synchronizer, and generating by the second two flip-flop synchronizer a second synchronizer output signal. The second two flip-flop synchronizer includes a second falling edge D flip-flop in series with a second rising edge D flip-flop, such as the second two flip-flop synchronizer 104 shown in Figures 3 and 4. The step 404 of receiving an input signal and a clock signal by a second two flip-flop synchronizer, and generating by the second two flip-flop synchronizer a second synchronizer output signal may include: receiving, by the second falling edge D flip-flop, the input signal and the clock signal; outputting, by the second falling edge D flip-flop, a second synchronizer meta signal; receiving, by the second rising edge D flip-flop the clock signal and the second synchronizer meta signal; and outputting by the second rising edge D flip-flop the second synchronizer output signal.

Steps 402 and 404 may occur simultaneously.

Subsequent to steps 402 and 404, the method 400 includes step 406, which includes passing the first synchronizer output signal and the second synchronizer output signal to at least one of a plurality of gates that implement a gate logic.

The method 400 may then continue by proceeding from step 406 to step 408, which includes generating by implementing the gate logic of the plurality of gates an enable signal and a D input signal. The gate logic implemented by the plurality of gates is consistent with the truth table provided in Table 1 above. In at least one example, generating the enable signal may include generating a high enable signal when the first synchronizer output signal is equal to the second synchronizer output signal, and generating a low enable signal when the first synchronizer output signal does not equal the second synchronizer output signal. Additionally, in at least one example, generating the D input signal may include generating a high D input signal when at least one of the first synchronizer output signal or the second synchronizer output signal is high, and generating a low D input signal when both of the first synchronizer output signal and the second synchronizer output signal are low. Further, in at least one example, generating the enable signal and the D input signal may include: generating a high enable signal when the first synchronizer output signal is equal to the second synchronizer output signal, generating a low enable signal when the first synchronizer output signal does not equal the second synchronizer output signal, generating a high D input signal when at least one of the first synchronizer output signal or the second synchronizer output signal is high, and generating a low D input signal when both of the first synchronizer output signal and the second synchronizer output signal are low.

The method 400 may continue to step 410, which includes receiving by a latch the enable signal and the D input signal and generating by the latch a dual edge synchronizer output signal, wherein a change in the state of the D input signal is passed as a change in the state of the dual edge synchronizer output signal when the enable signal is high and is not passed as the dual edge synchronizer output signal when the enable signal is low.

Notwithstanding the above description, the present disclosure is intended to encompass numerous embodiments including those disclosed herein as well as a variety of alternate embodiments.

Further, in at least some example embodiments encompassed herein, the present disclosure relates to dual edge synchronizers and methods of using dual edge synchronizers to filter out glitches.

Dual edge synchronizers and methods of using dual edge synchronizers to filter out glitches are provided. Dual edge synchronizers include a first two flip-flop synchronizer, a second two flip-flop synchronizer in parallel with the first two flip-flop synchronizer, a plurality of gates that receive the outputs from the two synchronizers and implement a gate logic to generate an enable signal and a D input signal that are passed to a latch. The latch generates a dual edge synchronizer output signal, wherein a change in the state of the D input signal is passed as a change in the state of the dual edge synchronizer output signal when the enable signal is high and is not passed as the dual edge synchronizer output signal when the enable signal is low.

In one aspect, a dual edge synchronizer is provided that comprises: a first two flip-flop synchronizer including a first rising edge D flip-flop in series with a first falling edge D flip-flop, wherein the first two flip-flop synchronizer receives an input signal and a clock signal and generates a first synchronizer output signal; a second two flip-flop synchronizer in parallel with the first synchronizer, the second two flip-flop synchronizer including a second falling edge D flip-flop in series with a second rising edge D flip-flop, wherein the second two flip-flop synchronizer receives the input signal and the clock signal and generates a second synchronizer output signal, a plurality of gates implementing a gate logic that generates an enable signal and a D input signal; and a latch that receives the enable signal and the D input signal and generates a dual edge synchronizer output signal, wherein a change in the D input signal is passed as a change in the dual edge synchronizer output signal when the enable signal is high and is not passed as the dual edge synchronizer output signal when the enable signal is low.

Dual edge synchronizers may also include one or more additional traits or features. For example, the gate logic implemented by the plurality of gates may result in: the enable signal being high when the first synchronizer output signal is equal to the second synchronizer output signal; and the enable signal being low when the first synchronizer output signal does not equal the second synchronizer output signal. Further, the gate logic implemented by the plurality of gates may result in: the D input signal being high when at least one of the first synchronizer output signal or the second synchronizer output signal if high; and the D input signal being low when both of the first synchronizer output signal and the second synchronizer output signal are low. In some instances, the gate logic implemented by the plurality of gates may result in: the enable signal being high when the first synchronizer output signal is equal to the second synchronizer output signal; the enable signal being low when the first synchronizer output signal does not equal the second synchronizer output signal; the D input signal being high when at least one of the first synchronizer output signal or the second synchronizer output signal is high; and the D input signal being low when both of the first synchronizer output signal and the second synchronizer output signal are low. As another example, the first rising edge D flip-flop of the first two flip-flop synchronizer may receive an input signal and a clock signal and outputs a first synchronizer meta signal, and the first falling edge D flip-flop receives the clock signal and the first synchronizer meta signal and outputs the first synchronizer output signal. Similarly, the second falling edge D flip-flop of the second two flip-flop synchronizer may receive an input signal and a clock signal and outputs a second synchronizer meta signal, and the second rising edge D flip-flop receives the clock signal and the second synchronizer meta signal and outputs the second synchronizer output signal.

In at least one example, the plurality of gates may include: an AND gate that receives the first synchronizer output signal and the second synchronizer output signal and outputs an AND gate output; a first OR gate that receives the first synchronizer output signal and the second synchronizer output signal and outputs the D input signal and a first OR gate output; and a second OR gate that receives the AND gate output and the first OR gate output (after being inverted by an inverter) and outputs the enable signal. In an alternative example, the plurality of gates may include: an XNOR gate that receives the first synchronizer output signal and the second synchronizer output signal and outputs the enable signal; and an OR gate that receives the first synchronizer output signal and the second synchronizer output signal and outputs the D input signal.

In some examples, the clock signal used in the dual edge synchronizer may be received from a destination clock. In some examples, the input signal received by the dual edge synchronizer may be received from a logic cloud.

In another aspect, a method of using a dual edge synchronizer to filter out glitches is provided, the method comprising: receiving an input signal and a clock signal by a first two flip-flop synchronizer, the first two flip-flop synchronizer including a first rising edge D flip-flop in series with a first falling edge D flip-flop, and generating by the first two flip-flop synchronizer a first synchronizer output signal; receiving the input signal and the clock signal by a second two flip-flop synchronizer, the second two flip-flop synchronizer including a second falling edge D flip-flop in series with a second rising edge D flip-flop, and generating by the second two flip-flop synchronizer a second synchronizer output signal; passing the first synchronizer output signal and the second synchronizer output signal to at least one of a plurality of gates that implement a gate logic; generating by implementing the gate logic of the plurality of gates an enable signal and a D input signal; receiving by a latch the enable signal and the D input signal and generating by the latch a dual edge synchronizer output signal, wherein a change in the state of the D input signal is passed as a change in the state of the Dual edge synchronizer output signal when the enable signal is high and is not passed as the dual edge synchronizer output signal when the enable signal is low to filter out the glitches.

In at least one example of a method, the step of generating by implementing the gate logic of the plurality of gates an enable signal and a D input signal may include: generating a high enable signal when the first synchronizer output signal is equal to the second synchronizer output signal; and generating a low enable signal when the first synchronizer output signal does not equal the second synchronizer output signal.

In at least one example of a method, the step of generating by implementing the gate logic of the plurality of gates an enable signal and a D input signal may include: generating a high D input signal when at least one of the first synchronizer output signal or the second synchronizer output signal is high; and generating a low D input signal when both of the first synchronizer output signal and the second synchronizer output signal are low.

In at least one example of a method, the step of generating by implementing the gate logic of the plurality of gates an enable signal and a D input signal may include: generating a high enable signal when the first synchronizer output signal is equal to the second synchronizer output signal; generating a low enable signal when the first synchronizer output signal does not equal the second synchronizer output signal; generating a high D input signal when at least one of the first synchronizer output signal or the second synchronizer output signal is high; and generating a low D input signal when both of the first synchronizer output signal and the second synchronizer output signal are low.

In at least one example of a method, the step of receiving an input signal and a clock signal by a first two flip-flop synchronizer and generating by the first two flip-flop synchronizer a first synchronizer output signal may include: receiving, by the first rising edge D flip-flop, the input signal and the clock signal; outputting, by the first rising edge D flip-flop, a first synchronizer meta signal; receiving, by the first falling edge D flip-flop the clock signal and the first synchronizer meta signal; and outputting by the first falling edge D flip-flop the first synchronizer output signal.

In at least one example of a method, the step of receiving an input signal and a clock signal by a second two flip-flop synchronizer and generating by the second two flip-flop synchronizer a second synchronizer output signal may include: receiving, by the second falling edge D flip-flop, the input signal and the clock signal; outputting, by the second falling edge D flip-flop, a second synchronizer meta signal; receiving, by the second rising edge D flip-flop the clock signal and the second synchronizer meta signal; and outputting by the second rising edge D flip-flop the second synchronizer output signal.

In an additional example aspect, the present disclosure relates to a system that includes a source of an input signal, a dual edge synchronizer, and a destination D flip-flop that receives a dual edge synchronizer output signal as a destination D flip-flop D input. The dual edge synchronizer includes a first two flip-flop synchronizer including a first rising edge D flip-flop in series with a first falling edge D flip-flop, where the first two flip-flop synchronizer receives an input signal and a clock signal and generates a first synchronizer output signal. Also, the dual edge synchronizer includes a second two flip-flop synchronizer in parallel with the first two flip-flop synchronizer, the second two flip-flop synchronizer including a second falling edge D flip-flop in series with a second rising edge D flip-flop, where the second two flip-flop synchronizer receives the input signal and the clock signal and generates a second synchronizer output signal. Further, the dual edge synchronizer includes a plurality of gates implementing a gate logic that generates an enable signal and a D input signal, and a latch that receives the enable signal and the D input signal and generates the dual edge synchronizer output signal, where a change in state of the D input signal is passed as a change in state of the dual edge synchronizer output signal when the enable signal is high and is not passed as the dual edge synchronizer output signal when the enable signal is low.

Also, in at least one further example of the system, an input to a logic cloud that outputs the input signal is provided by one or more source flip-flops. Further, in an additional example of the system, the plurality of gates of the dual edge synchronizer includes: an AND gate that is arranged to receive the first synchronizer output signal and the second synchronizer output signal and outputs an AND gate output; a first OR gate that is arranged to receive the first synchronizer output signal and the second synchronizer output signal and outputs the D input signal and a first OR gate output; and a second OR gate that is arranged to receive the AND gate output and the first OR gate output (after being inverted by an inverter) and outputs the enable signal. Also, in a further example of the system, the plurality of gates of the dual edge synchronizer includes: an XNOR gate that is arranged to receive the first synchronizer output signal and the second synchronizer output signal and outputs the enable signal; and an OR gate that is arranged to receive the first synchronizer output signal and the second synchronizer output signal and outputs the D input signal.

Dual edge synchronizers of the present technology may be useful in a variety of applications. Indeed, dual edge synchronizers of the present technology may be applied wherever CDC convergence is unavoidable and at an input pin having glitches of width less than half of the cycle of operating clock. For example, they may be used as synchronizers for CDC interfaces with unavoidable convergence due to any reason (e.g., absence of a source clock). As another example, they may be used in low overhead glitch filter logic in communication protocols for sensors and onboard cores. As yet another example, they may be targeted for any logic where CDC is needed with glitch suppression.

One or more of the embodiments encompassed herein can be advantageous in any of a variety of respects. For example, dual edge synchronizers of the present technology may provide a robust solution at the CDC convergence interface, and may avoid passing small glitches erroneously as valid pulses. Accordingly, dual edge synchronizers of the present technology may reduce or prevent functional failures in gate level simulation and silicon. Dual edge synchronizers of the present technology may also provide lower latency from input to output than conventional processing.

While the principles of the invention have been described above in connection with specific apparatus, it is to be clearly understood that this description is made only by way of example and not as a limitation on the scope of the invention. It is specifically intended that the present invention not be limited to the embodiments and illustrations contained herein, but include modified forms of those embodiments including portions of the embodiments and combinations of elements of different embodiments as come within the scope of the following claims.

## Claims

1. A dual edge synchronizer comprising:
a first two flip-flop synchronizer including a first rising edge D flip-flop in series with a first falling edge D flip-flop, wherein the first two flip-flop synchronizer receives an input signal and a clock signal and generates a first synchronizer output signal;
a second two flip-flop synchronizer in parallel with the first two flip-flop synchronizer, the second two flip-flop synchronizer including a second falling edge D flip-flop in series with a second rising edge D flip-flop, wherein the second two flip-flop synchronizer receives the input signal and the clock signal and generates a second synchronizer output signal,
a plurality of gates implementing a gate logic that generates an enable signal and a D input signal; and
a latch that receives the enable signal and the D input signal and generates a dual edge synchronizer output signal, wherein a change in state of the D input signal is passed as a change in state of the dual edge synchronizer output signal when the enable signal is high and is not passed as the dual edge synchronizer output signal when the enable signal is low.

2. The dual edge synchronizer of claim 1, wherein the gate logic implemented by the plurality of gates results in:
the enable signal being high when the first synchronizer output signal is equal to the second synchronizer output signal; and
the enable signal being low when the first synchronizer output signal does not equal the second synchronizer output signal.

3. The dual edge synchronizer of any preceding claim, wherein the gate logic implemented by the plurality of gates results in:
the D input signal being high when at least one of the first synchronizer output signal or the second synchronizer output signal is high; and
the D input signal being low when both of the first synchronizer output signal and the second synchronizer output signal are low.

4. The dual edge synchronizer of any preceding claim, wherein the gate logic implemented by the plurality of gates results in:
the enable signal being high when the first synchronizer output signal is equal to the second synchronizer output signal;
the enable signal being low when the first synchronizer output signal does not equal the second synchronizer output signal;
the D input signal being high when at least one of the first synchronizer output signal or the second synchronizer output signal is high; and
the D input signal being low when both of the first synchronizer output signal and the second synchronizer output signal are low.

5. The dual edge synchronizer of any preceding claim, wherein the first rising edge D flip-flop of the first two flip-flop synchronizer receives an input signal and a clock signal and outputs a first synchronizer meta signal, and the first falling edge D flip-flop receives the clock signal and the first synchronizer meta signal and outputs the first synchronizer output signal.

6. The dual edge synchronizer of any preceding claim, wherein the second falling edge D flip-flop of the second two flip-flop synchronizer receives an input signal and a clock signal and outputs a second synchronizer meta signal, and the second rising edge D flip-flop receives the clock signal and the second synchronizer meta signal and outputs the second synchronizer output signal.

7. The dual edge synchronizer of any preceding claim, wherein the plurality of gates includes:
an AND gate that receives the first synchronizer output signal and the second synchronizer output signal and outputs an AND gate output;
a first OR gate that receives the first synchronizer output signal and the second synchronizer output signal and outputs the D input signal and a first OR gate output; and
a second OR gate that receives the AND gate output and the first OR gate output and outputs the enable signal.

8. The dual edge synchronizer of any preceding claim, wherein the plurality of gates includes:
an XNOR gate that receives the first synchronizer output signal and the second synchronizer output signal and outputs the enable signal; and
an OR gate that receives the first synchronizer output signal and the second tput signal and outputs the D input signal.

9. The dual edge synchronizer of any preceding claim, wherein the clock signal is received from a destination clock.

10. The dual edge synchronizer of any preceding claim, wherein the input signal is received from a logic cloud.

11. A method of using a dual edge synchronizer to filter out glitches, the method comprising:
receiving an input signal and a clock signal by a first two flip-flop synchronizer, the first two flip-flop synchronizer including a first rising edge D flip-flop in series with a first falling edge D flip-flop, and generating by the first two flip-flop synchronizer a first synchronizer output signal;
receiving the input signal and the clock signal by a second two flip-flop synchronizer, the second two flip-flop synchronizer including a second falling edge D flip-flop in series with a second rising edge D flip-flop, and generating by the second two flip-flop synchronizer a second synchronizer output signal;
passing the first synchronizer output signal and the second synchronizer output signal to at least one of a plurality of gates that implement a gate logic;
generating by implementing the gate logic of the plurality of gates an enable signal and a D input signal; and
receiving by a latch the enable signal and the D input signal and generating by the latch a dual edge synchronizer output signal, wherein a change in state of the D input signal is passed as a change in state of the Dual edge synchronizer output signal when the enable signal is high and is not passed as the dual edge synchronizer output signal when the enable signal is low to filter out the glitches.

12. The method of claim 11, wherein generating by implementing the gate logic of the plurality of gates an enable signal and a D input signal includes:
generating a high enable signal when the first synchronizer output signal is equal to the second synchronizer output signal; and
generating a low enable signal when the first synchronizer output signal does not equal the second synchronizer output signal.

13. The method of any of claims 11 to 12, wherein generating by implementing the gate logic of the plurality of gates an enable signal and a D input signal includes:
generating a high D input signal when at least one of the first synchronizer output signal or the second synchronizer output signal is high; and
generating a low D input signal when both of the first synchronizer output signal and the second synchronizer output signal are low.

14. The method of any of claims 11 to 13, wherein generating by implementing the gate logic of the plurality of gates an enable signal and a D input signal includes:
generating a high enable signal when the first synchronizer output signal is equal to the second synchronizer output signal;
generating a low enable signal when the first synchronizer output signal does not equal the second synchronizer output signal;
generating a high D input signal when at least one of the first synchronizer output signal or the second synchronizer output signal is high; and
generating a low D input signal when both of the first synchronizer output signal and the second synchronizer output signal are low.

15. The method of any of claims 11 to 14, wherein receiving an input signal and a clock signal by a first two flip-flop synchronizer and generating by the first two flip-flop synchronizer a first synchronizer output signal includes:
receiving, by the first rising edge D flip-flop, the input signal and the clock signal;
outputting, by the first rising edge D flip-flop, a first synchronizer meta signal;
receiving, by the first falling edge D flip-flop the clock signal and the first synchronizer meta signal; and
outputting by the first falling edge D flip-flop the first synchronizer output signal.
